# EUROPEAN PATENT SPECIFICATION

(11) **EP 0 368 089 B1**
(45) Date of publication and mention of the grant of the patent: **08.03.1995**
(21) Application number: 89119950.7
(22) Date of filing: 27.10.1989
(51) Int. Cl.: G03F 1/16

(54) **Method of manufacturing a mask for lithographic patterning**
Herstellungsverfahren für eine Maske für lithographische Strukturierung
Procédé de fabrication d'un masque pour la texturation lithographique

(30) Priority: 07.11.1988 JP 280671/88
(43) Date of publication of application: 16.05.1990
(73) Proprietor: FUJITSU LIMITED, Kawasaki-shi, Kanagawa 211 (JP)
(72) Inventor: Sakamoto, Kiichi, Toshima-ku Tokyo, 170 (JP); Yasuda, Hiroshi, Yokohama-shi Kanagawa, 222 (JP)
(74) Representative: Seeger, Wolfgang, Dipl.-Phys.

(56) References cited:
- EP-A- 0 001 038
- EP-A- 0 019 779
- EP-A- 0 212 713
- WO-A-89/06045
- FR-A- 2 316 635

## Description

### BACKGROUND OF THE INVENTION

The present invention generally relates to lithographic patterning of semiconductor substrate and more particularly to a method of manufacturing a mask for lithographic patterning of semiconductor substrate.

With continuous demand to increase the integration density of integrated circuits, new lithography technique such as electron beam lithography or X-ray beam lithography is now under intensive study. According to such a new lithography technique, a fine patterning with a pattern size of 1 »m or less can be achieved easily.

In the electron beam lithography, a mask having an aperture for passing an electron beam according to a predetermined pattern is used for shaping the electron beam. In using such a mask, it is required that the mask is manufactured easily with high precision. Further, the mask is required that it can be used repeatedly.

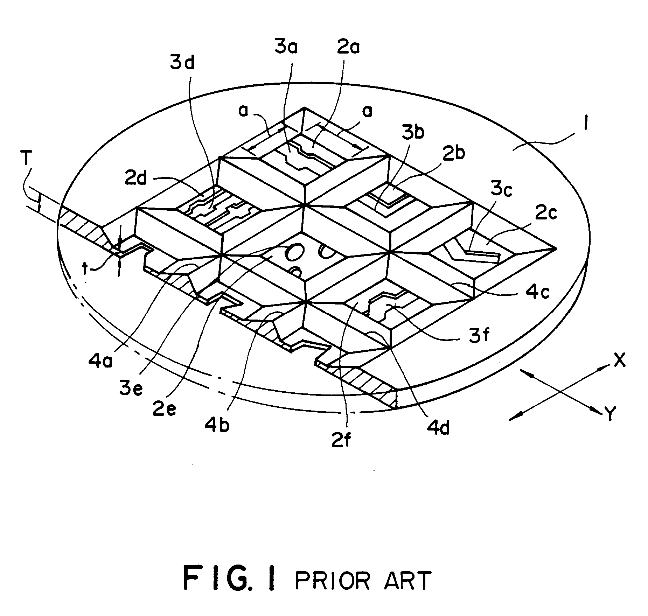

FIG.1 shows a typical prior art mask used for electron beam lithography as viewed from a bottom side thereof. Referring to the drawing, the mask comprises a base body 1 of silicon and there are provided a plurality of pattern regions 2 such as the regions 2a - 2f each having a size of about 300 X 300 »m. In the pattern regions 2, a plurality of apertures 3a - 3f are formed respectively according to desired beam shapes. Further, there are provided a plurality of reinforcement ribs 4a - 4c on the base body 1 so as to surround the pattern regions 2a - 2f to provide a rigidity thereto. The pattern regions 2a - 2f generally have an extremely small thickness in the order of 1 »m or less because of the reason to be described and because of this, the pattern regions have to be reinforced by the reinforcement ribs 4a - 4c.

In such a prior art mask, however, use of the reinforcement ribs decreases the number of the pattern regions which can be provided on the mask. Further, such a rib makes the manufacturing of the mask extremely difficult or even unrealistic. In other words, the mask with a structure as shown in FIG.1 is virtually impossible to construct with reliability for practical use. When the ribs are omitted, on the other hand, the number of pattern regions on the mask is reduced to only one and the efficiency of the patterning process is significantly reduced as the mask has to be replaced each time the pattern to be written on the substrate is changed. Note that one pattern region can carry only one pattern, if not provided with such reinforcement, because of the reduced size of the pattern region.

In such a prior art mask, there is a further problem in that the thin mask region, being irradiated by the high energy electron beam, tends to be heated. When such heating occurs, the mask region is easily deformed and the pattern transferred on the semiconductor substrate is deformed. It is needless to mention the difficulty in handling such a fragile mask. Further, because of the reduced thickness of the pattern regions, some of the electron beams are passed through the pattern regions with substantial scattering, and thus there arises another problem in which the contour of the image transferred on the semiconductor substrate is blurred.

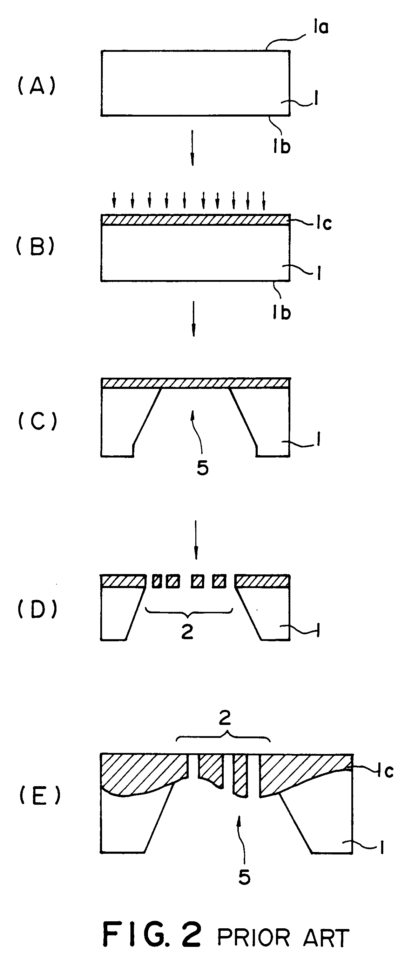

Conventionally, the mask shown in FIG.1 is formed by a series of doping and etching processes as shown in FIGS.2(A) - (D). In these drawings, the reinforcement ribs are omitted for the sake of simplicity.

Referring to FIG.2(A), a silicon base body 1 is prepared with a thickness of about 500 »m such that the base body has a (100) top surface 1a and a (100) bottom surface 1b. In a next step of FIG.2(B), the top surface 1a is doped with boron by ion implantation and a boron-doped region 1c is formed. As the region 1c is formed by the ion implantation, the thickness of the region 1c is very thin in the order of a few hundred nanometers in the maximum, typically about 0.2 »m. Next, the bottom surface 1b of the base body 1 is etched in a solution of potassium hydrooxide (KOH) whereby a (111) plane of silicon is preferentially etched and a space 5 as shown in FIG.2(C) is formed. Note that the etching of silicon by KOH is stopped at the boron-doped region 1c because of the reduced etching rate. Further, the boron-doped region 1c is patterned and a structure shown in FIG.2(D) is obtained.

It will now be understood the reason why the thickness of the pattern region 2 has been so small in the prior art mask. Associated with the formation of the region 1c by doping, there arises another problem in that the lower boundary of the boron-doped region 1c is not flat. In other words, there is some undulation in the lower boundary of the region 1c as shown in FIG.2(E). Such an undulation of the doped region is usually negligible in the manufacturing of integrated circuits as the lateral extent of such a doped region in the semiconductor device is uncomparably small. In the case of the mask, however, the lateral extent of such a region is in the order of several hundred microns to several millimeters and thus the pattern region 2 can have a substantial variation in the thickness. Such a variation can provide a substantial effect on the patterning process such as the change in the focusing of the electron beam on the semiconductor substrate.

Further, associated with the undulation of the lower boundary of the doped region 1c, there arises a still other problem in that the size of the aperture formed in a part of the pattern region 2 having a reduced thickness tends to be enlarged as compared to the apertures in a thick part because of the excessive etching.

### SUMMARY OF THE INVENTION

Another and more specific object of the present invention is to provide a method of manufacturing a mask for lithographic patterning of a semiconductor substrate having an excellent dimensional precision and for allowing a repeated use.

Another object of the present invention is to provide a mask for lithographic patterning of a semiconductor substrate which can be manufactured easily.

These objects are obtained by a method of manufacturing a mask for lithographic patterning, comprising the steps of: bonding a silicon substrate on a top side of a base body, said base body having a silicon oxide-layer at least on said top side; polishing the silicon substrate bonded to the base body uniformly such that the silicon substrate has a reduced thickness which is smaller than about 20 »m but larger than about 2 »m patterning the silicon substrate to form a mask pattern region in the silicon substrate such that a plurality of mask patterns are provided in that mask pattern region in the form of apertures; and etching the base body such that a part of the base body located under the mask pattern region is removed, said step of etching comprising a first step for etching the base body starting from a bottom side of the base body to expose the silicon oxide layer, and a second step for selectively etching the silicon oxide layer.

Other objects and further features of the present invention will become apparent from the following detailed description when read in conjunction with attached drawings.

### BRIEF DESCRIPTION OF THE DRAWINGS

FIG.1 is a perspective view showing bottom side of a prior art mask;
FIGS.2(A) - (E) are diagrams showing a manufacturing process of the mask of FIG.1 and a problem thereof;
FIGS.3(A) and (B) are respectively a perspective view showing a bottom side of a mask made according to a first embodiment of the manufacturing method of the present invention and a cross sectional view thereof;
FIGS.4(A) - (E) are diagrams showing various steps for manufacturing the mask of FIG.3(A); and
FIGS.5(A) - (E) are diagrams similar to FIGS.4(A) - (E) showing various steps for manufacturing the mask made according to a second embodiment of the manufacturing method of the present invention.

### DETAILED DESCRIPTION

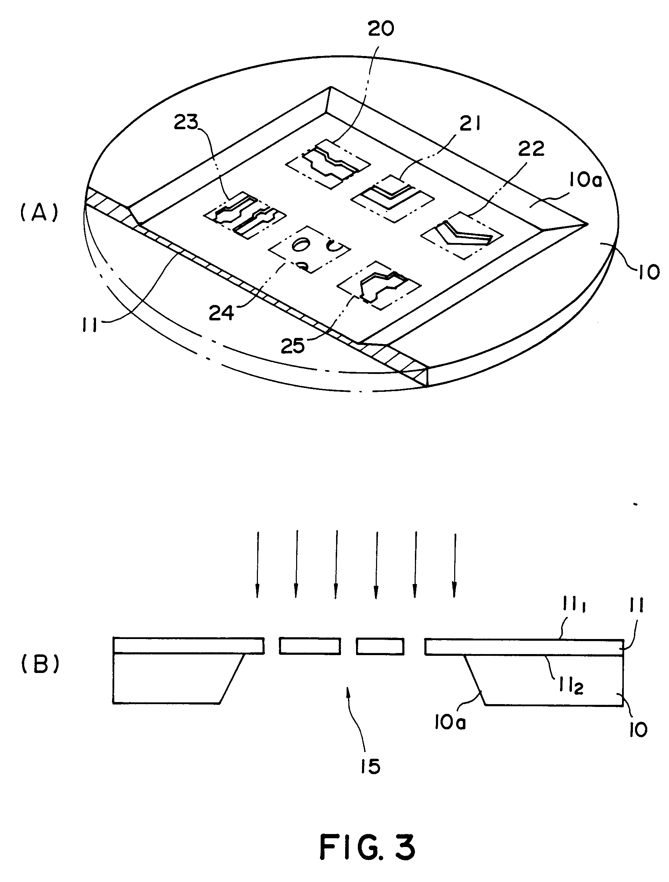

FIG.3(A) is a perspective view showing a bottom side of the mask made according to a first embodiment of the method of the present invention and FIG.3(B) is a cross sectional view thereof. Referring to FIG.3(A), the mask comprises a generally circular base body 10 of a silica or silicate glass on which a mask layer 11 of silicon is provided. As can be seen in the cross sectional view of FIG.3(B), the base body 10 is provided with a large cutout or through hole 15 defined by an inner wall 10a, and the through hole 15 is closed by the mask layer 11 at the top of the base body 10 having a flat top surface 11₁ and a flat bottom surface 11₂. In one example, the cutout 10a has a size of about 40 mm X 40 mm.

On the mask layer 11, there are provided a plurality of patterning apertures 20 - 25 as shown in FIG.3(A) in correspondence to the through hole 15. The mask layer 11 typically has a thickness of about 2 »m to 20 »m and thus has a substantial rigidity. In other words, the mask layer 11 can extend over the through hole 15 without reinforcement in contrast to the prior art mask, in which the pattern region 2 corresponding to the mask layer 11 is extremely fragile and needed the reinforcement by the ribs 4a - 4d. Each of the apertures 20 - 25 has a size of typically about 300 »m X 300 »m and thus about 200 patterning apertures can be provided on a part of the mask layer 11 having a size of about 5 X 5 mm which is a typical size of an area which can be addressed by deflection of an electron beam while without moving the mask. Note that the size of the apertures is exaggerated in FIG.3.

In the mask made according to the present invention, because of the substantial thickness and rigidity of the mask layer 11, a large number of patterning apertures can be provided on the mask layer 11. As a result, the patterning process can be carried out efficiently as the step of moving or replacing the mask during the exposure can be eliminated. Further, the deformation of the mask layer 11 associated with the heating by the electron beam can be eliminated because of the increased rigidity of the mask layer 11. At the same time, the handling of the mask becomes easier and the mask can be used repeatedly for a number of times. Further, the passing-through of the electron beam through the mask layer 11 for a part not provided with the patterning aperture is positively prevented by the increased thickness of the mask layer 11 and a sharp image can be formed on a semiconductor wafer (not shown) to be patterned. Furthermore, the mask is easily manufactured by a simple process.

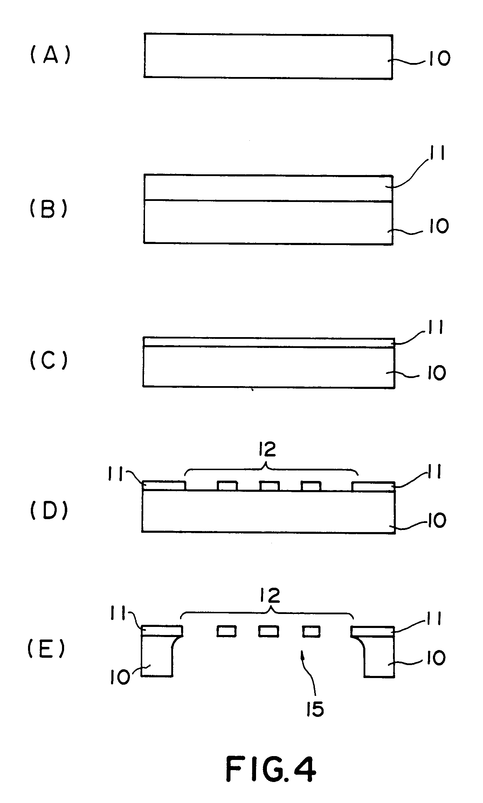

Next, manufacturing process of the mask of FIGS.3(A) and (B) will be described with reference to FIGS.4(A) - (E).

In a step of FIG.4(A), the base body 10 of a silica glass disk is prepared with a typical diameter of about several centimeters and a typical thickness of about 500 »m. Next, in a step of FIG.4(B), a silicon substrate 11a having a corresponding circular shape and a thickness of several hundred microns is jointed on a surface of the base body 10. The jointing of the base body 10 and the silicon substrate 11a is performed at a temperature of 900 to 1000 °C while contacting the base body 10 and the substrate 11a wherein the silicon substrate 11a is welded to the base body 10 via a thin oxide film (not shown) formed on the surface of the silicon substrate.

Next, the thickness of the silicon substrate 11a is reduced as shown in FIG.4(C) by lapping using a diamond paste or other suitable abrasives until the mask layer 11 has a desired thickness which is generally less than about 20 »m but larger than about 2 »m. When the thickness is larger than about 20 »m, the dimensional precision of the pattern transferred to the semiconductor wafer is deteriorated because of the change in the focusing of the electron beam. In a step of FIG.4(D), the entire surface of the mask layer 11 is covered by a photoresist (not shown) and after suitable patterning of the photoresist, a mask pattern 12 comprising a number of patterned apertures shown in FIG.3(A) is formed as a result of etching. After removal of the photoresist, a structure shown in FIG.4(D) is obtained.

Next, in a step of FIG.4(E), a part of the base body 10 located below the mask pattern 12 is removed by etching which may be a wet etching using a solution of hydrofluoric acid (HF) and there is provided a path of electron beam through the mask layer 11 according to the predetermined apertures.

According to the foregoing process, the thickness of the mask layer 11 is controlled by well established lapping process. According to the currently available technique, a thickness of about 2 »m or more is achieved with reliability. Note that the thickness below about 2 »m is undesirable for the mask layer 11 because of the reduced rigidity which tends to cause various problems associated with the prior art mask. When the thickness of the mask layer 11 is increased beyond about 20 »m, on the other hand, the foregoing deterioration in the accuracy of focusing is caused because of the too large thickness of the mask layer.

In the present invention, by applying the well established lapping process, the mask layer 11 has a uniform and exactly controlled thickness in the foregoing range of about 2 »m to 20 »m, and the unwanted variation of the size of the apertures 20 - 25, which is caused as a result of the excessive or insufficient etching which in turn is caused as a result of the non-uniform thickness of the mask layer 11, is positively eliminated.

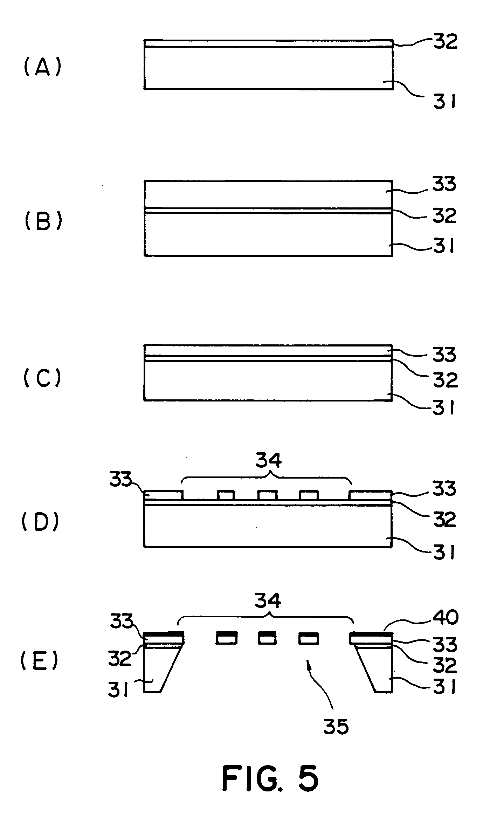

Next, a second embodiment of a manufacturing process of a mask of the present invention will be described with reference to FIGS.5(A) - (E). As the perspective view of this mask is substantially identical to that of the mask of the first embodiment, the illustration of the perspective view will be omitted. Further, those parts already described with the preceding drawings are given identical reference numerals and the description thereof will be omitted.

In the first step, a silicon substrate 31 having a (100) top surface is subjected to thermal oxidation whereby the base body 10 is formed as the silicon substrate 31 having a thin surface oxide layer 32 on the top surface as shown in FIG.5(A). Preferrably, the the oxide layer 32 has a thickness of about 1 um or less, although such a limitation in the thickness is not absolutely necessary.

In a step of FIG.5(B), another silicon substrate 33 is contacted with the surface oxide layer 32, and after an annealing in a temperature range between 900 °C and 1000 °C, the silicon substrate 33 is welded to the silicon substrate 32 via the surface oxide layer 32. Thus, a structure in which the surface oxide layer 32 is sandwiched between the silicon substrate 31 and the silicon substrate 33 is obtained.

Next, the silicon substrate 33 at the top of the structure of FIG.5(B) is subjected to lapping whereby the thickness of the substrate 33 is reduced to about 20 »m or less but larger than about 2 »m. Further, a photoresist (not shown) is provided on the entire surface of the substrate 33 and after a suitable patterning for defining a desirably patterned apertures to be formed on the mask, the silicon substrate 33 is subjected to etching similarly to the foregoing embodiment. As a result of the etching, a structure shown in FIG.5(D) is formed in which the foregoing apertures 20 - 25 are formed on a mask region 34 in the substrate 33.

Further, the silicon substrate 31 is subjected to anisotropic etching by a KOH solution wherein the (111) plane of silicon in the substrate 31 is preferentially etched. For this purpose, the entire structure of FIG.5(D) is covered except for an etching window (not shown) at a bottom side of the substrate 31. In a case where the substrate 31 has a thickness of 500 »m and where the mask region 34 has a desired size of 500 »m X 500 »m, an etching window having a size of about 1200 »m X 1200 »m is required.

When the etching has reached the silicon oxide layer 32, the etching rate is decreased and the etching is stopped. Thereafter, the silicon oxide layer 32 below the mask region 34 is removed by etching using HF. As a result, a space 35 is formed in the base body 31 in correspondence to the mask region 34 and a mask having a structure as shown in FIG.5(E) is obtained.

In any of the foregoing embodiments, a metal layer 40 of tantalum and the like may be provided on the silicon substrate 11 or 33 as shown in FIG.5(E), for example, for dissipating heat produced at the time the electron beam is irradiated.

The mask made by the method of the present invention is useful particularly in the electron beam lithography system for providing a desired cross section to the electron beam. However, the present invention is not limited as such but the mask is applicable also in other charged particle beam lithography system in general.

Further, the present invention is not limited to these embodiments described heretofore but various variations and modifications may be made without departing from the scope of the claims.

## Claims

1. A method of manufacturing mask for lithographic patterning, characterized by the steps of: bonding a silicon substrate (11, 33) on a top side of a base body (10, 31), said base body having a silicon oxide layer (32) at least on said top side; polishing the silicon substrate bonded to the base body uniformly such that the silicon substrate has a reduced thickness which is smaller than about 26 »m but larger than about 2 »m patterning the silicon substrate to form a mask pattern region (12, 34) in the silicon substrate such that a plurality of mask patterns (20-25) are provided in that mask pattern region in the form of apertures; and etching the base body such that a part of the base body located under the mask pattern region is removed, said step of etching comprising a first step for etching the base body starting from bottom side of the base body to expose the silicon oxide layer, and a second step for selectively etching the silicon oxide layer.

2. A method as claimed in claim 1 characterized in that said step of reducing the thickness comprises lapping of the silicon substrate (11, 33).

3. A method as claimed in claim 1 or 2, characterized in that each of said mask patterns (12, 34) has a size of at least about 300 »m X 300 »m.

4. A method as claimed in any of claims 1 to 3 characterized in that said step of bonding the silicon substrate on the top side of the base body comprises a step of annealing the silicon substrate and the Base body at a temperature between 900°C and 1000°C in a state that the silicon substrate and the base body are contacted each other.

5. A method as claimed in any of claims 1 to 4 characterized in that said base body (10) comprises a glass containing silicon oxide and said step of etching comprising a step of isotropic etching process using a fluoride etching agent.

6. A method as claimed in any of claims 1 to 4 characterized in that said base body comprises a silicon body carrying the silicon oxide layer and said step of bonding the silicon substrate further comprises a step of providing the silicon oxide layer on the top side of the base body by thermal oxidation of silicon.

7. A method as claimed in claim 6 chacterized in that said first step of etching comprises an anisotropic etching of the silicon body using a solution of potassium hydroxide and said second step of etching comprises an isotropic etching of the silicon oxide layer by a fluoride etching agent.

8. A method as claimed in any of claims 1 to 7 characterized in that the method further comprises a step of depositing a metal layer (40) on the silicon substrate (33) after the step of patterning.

## Patentansprüche

1. Verfahren zur Herstellung einer Maske für lithographisches Mustern, gekennzeichnet durch die Schritte: Bonden eines Silicium-Substrats (11, 33) an die Oberseite eines Basiskörpers (10, 31), welcher Basiskörper eine Siliciumoxid-Schicht (32) zumindest an der genannten Oberseite aufweist; gleichmäßiges Polieren des an den Basiskörper gebondeten Silicium-Substrats, so daß das Silicium-Substrat eine reduzierte Dicke hat, die kleiner ist als etwa 20 »m, jedoch größer als etwa 2 »m; Mustern des Silicium-Substrats, um eine Maskenmusterzone (12, 34) im Silicium-Substrat zu bilden, so daß eine Vielzahl von Maskenmustern (20 bis 25) in jeder Maskenmusterzone in Form von Aperturen vorgesehen wird; und Ätzen des Basiskörpers, so daß ein Teil des Basiskörpers, der unter der Maskenmusterzone angeordnet ist, entfernt wird, welcher Ätzschritt einen ersten Schritt zum Ätzen des Basiskörpers ausgehend von der Unterseite des Basiskörpers, um die Siliciumoxid-Schicht freizulegen, und einen zweiten Schritt zum selektiven Ätzen der Siliciumoxid-Schicht umfaßt.

2. Verfahren nach Anspruch 1, dadurch gekennzeichnet, daß der genannte Schritt des Reduzierens der Dicke das Läppen des Silicium-Substrats (11, 33) umfaßt.

3. Verfahren nach Anspruch 1 oder 2, dadurch gekennzeichnet, daß jedes der genannten Maskenmuster (12, 34) eine Größe von zumindest etwa 300 »m x 300 »m aufweist.

4. Verfahren nach einem der Ansprüche 1 bis 3, dadurch gekennzeichnet, daß der genannte Schritt des Bondens des Silicium-Substrats an die Oberseite des Basiskörpers einen Schritt des Ausheilens des Silicium-Substrats und des Basiskörpers bei einer Temperatur zwischen 900°C und 1000°C in einem Zustand, in dem das Silicium-Substrat und der Basiskörper miteinander in Kontakt stehen, umfaßt.

5. Verfahren nach einem der Ansprüche 1 bis 4, dadurch gekennzeichnet, daß der genannte Basiskörper (10) Glas enthaltendes Siliciumoxid umfaßt, und der genannte Ätzschritt ein isotropes Ätzverfahren unter Verwendung eines Fluorid-Ätzmittels umfaßt.

6. Verfahren nach einem der Ansprüche 1 bis 4, dadurch gekennzeichnet, daß der genannte Basiskörper einen Silicium-Körper, der die Siliciumoxid-Schicht trägt, umfaßt, und der genannte Schritt des Bondens des Silicium-Substrats ferner einen Schritt des Vorsehens der Siliciumoxid-Schicht auf der Oberseite des Basiskörpers durch Silicium-Wärmeoxidation umfaßt.

7. Verfahren nach Anspruch 6, dadurch gekennzeichnet, daß der genannte erste Ätzschritt anisotropes Ätzen des Silicium-Körpers unter Verwendung einer Kaliumhydroxid-Lösung umfaßt, und der genannte zweite Ätzschritt isotropes Ätzen der Siliciumoxid-Schicht mit einem Fluorid-Ätzmittel umfaßt.

8. Verfahren nach einem der Ansprüche 1 bis 7, dadurch gekennzeichnet, daß das Verfahren ferner einen Schritt des Abscheidens einer Metallschicht (40) auf dem Silicium-Substrat (33) nach dem Musterungsschritt umfaßt.

## Revendications

1. Procédé de fabrication d'un masque pour formation de motifs de gravure, caractérisé par les étapes : de liaison d'un substrat de silicium (11, 33) à la face supérieure d'un corps de base (10, 31), ledit corps de base portant, au moins sur ladite face supérieure, une couche d'oxyde de silicium (32) ; de rodage du substrat de silicium lié au corps de base uniformément de manière à donner au substrat de silicium une épaisseur réduite qui soit plus petite qu'environ 20 »m mais supérieure à environ 2 »m ; de formation de motifs sur le substrat de silicium pour former une région de motifs de masque (12, 34) dans le substrat de silicium de manière à disposer plusieurs motifs de masque (20 à 25) dans cette région de motifs de masque sous la forme d'ouvertures ; et d'attaque du corps de base de manière à éliminer la partie du corps de base située sous la région de motifs de masque ; ladite étape d'attaque comprenant une première étape d'attaque du corps de base en partant de la face inférieure du corps de base pour mettre à nu la couche d'oxyde de silicium, et une seconde étape d'attaque sélective de la couche d'oxyde de silicium.

2. Procédé selon la revendication 1, caractérisé en ce que ladite étape de réduction de l'épaisseur comprend le rodage du substrat de silicium (11, 33).

3. Procédé selon la revendication 1 ou 2, caractérisé en ce que chacun desdits motifs de masque (12, 34) a une taille d'au moins environ 300 »m x 300 »m.

4. Procédé selon l'une quelconque des revendications 1 à 3, caractérisé en ce que ladite étape de liaison du substrat de silicium à la face supérieure du corps de base comprend une étape de recuit du substrat de silicium et du corps de base à une température située entre 900° C et 1.000° C dans un état où le substrat de silicium et le corps de base sont mis en contact l'un avec l'autre.

5. Procédé selon l'une quelconque des revendications 1 à 4, caractérisé en ce que ledit corps de base (10) est constitué par un verre contenant de l'oxyde de silicium et en ce que ladite étape d'attaque comprend une étape d'attaque isotropique en utilisant un agent d'attaque à base de fluorure.

6. Procédé selon l'une quelconque des revendications 1 à 4, caractérisé en ce que ledit corps de base comprend un corps de silicium portant la couche d'oxyde de silicium et en ce que ladite étape de liaison du substrat de silicium comprend en outre une étape de création, par oxydation thermique du silicium, d'une couche d'oxyde de silicium sur la face supérieure du corps de base.

7. Procédé selon la revendication 6, caractérisé en ce que ladite première étape d'attaque comprend une attaque anisotropique du corps de silicium en utilisant une solution d'hydroxyde de potassium et en ce que ladite deuxième étape d'attaque comprend une attaque isotropique de la couche d'oxyde de silicium par un agent d'attaque à base de fluorure.

8. Procédé selon l'une quelconque des revendications 1 à 7, caractérisé en ce que ledit procédé comprend en outre une étape de dépôt d'une couche de métal (40) sur le substrat de silicium (33) après l'étape de formation de motifs.
